# EUROPÄISCHE PATENTSCHRIFT

(11) **EP 1 966 839 B1**
(45) Veröffentlichungstag und Bekanntmachung des Hinweises auf die Patenterteilung: **07.03.2012**
(21) Anmeldenummer: 06818122.1
(22) Anmeldetag: 08.12.2006
(51) Int. Cl.: H01L 41/083, B64C 3/38, B64C 3/48

(54) **DREIDIMENSIONALES STAPELPIEZOELEMENT UND PIEZOELEKTRISCHER AKTUATOR MIT EINEM SOLCHEN STAPELPIEZOELEMENT**
THREE-DIMENSIONAL STACKED PIEZOELEMENT, AND PIEZOELECTRIC ACTUATOR HAVING SUCH A STACKED PIEZOELEMENT
ÉLÉMENT PIÉZO EMPILÉ TRIDIMENSIONNEL ET ACTIVATEUR PIÉZOÉLECTRIQUE COMPORTANT UN TEL ÉLÉMENT PIÉZO EMPILÉ

(30) Priorität: 21.12.2005 DE 102005061752
(43) Veröffentlichungstag der Anmeldung: 10.09.2008
(73) Patentinhaber: EADS Deutschland GmbH, 85521 Ottobrunn (DE)
(72) Erfinder: GROHMANN, Boris, 82024 Taufkirchen (DE); KONSTANZER, Peter, 82024 Taufkirchen (DE); STORM, Stefan, 85716 Unterschleissheim (DE)
(86) Internationale Anmeldenummer: PCT/DE2006/002189
(87) Internationale Veröffentlichungsnummer: WO 2007/071231

(56) Entgegenhaltungen:
- EP-A1- 0 100 275
- WO-A-96/31333
- WO-A1-01/31715
- DE-A1- 19 712 034
- DE-A1- 19 732 571
- US-A- 3 873 191
- US-A- 4 803 763
- US-B1- 6 404 107

## Beschreibung

Die Verwendung von piezoelektrischen Elementen ist allgemein bekannt. Solche Piezoelemente werden z.B. dazu eingesetzt, Verformungen an Bauteilen zu erfassen, wenn Piezoelemente an Bauteilen angebracht sind und mit der am Bauteil erzeugten Verformung mitbewegt werden. Dabei wird ausgenutzt, dass bei einer Verformung eines Piezoelements in diesem eine Ladungsverschiebung hervorgerufen wird. Andererseits dienen Piezoelemente auch dazu, gezielt ein Bauteil zu beeinflussen und insbesondere zu verformen, indem umgekehrt das Piezoelement mit Spannung versorgt wird und die daraus resultierende Verformung ausgenutzt wird. Piezoelemente finden vor allem dann Anwendung, wenn spezielle, komplexe Verformungsvorgänge am Bauteil erforderlich sind und die Oberfläche des Bauteils in allen Verformungszuständen möglichst unversehrt und glatt sein soll. Anwendungsbeispiele finden sich z.B. in der Luftfahrttechnik bei aerodynamischen Profilen, aber auch für große Hohlspiegel in z.B. Teleskopen und vieles mehr.

Beispielsweise im Bereich der Luftfahrtechnik werden Piezoelemente zur Untersuchung von aerodynamischen Profilen eingesetzt, wenn die Profile im Hinblick auf ihre Umströmungseigenschaften untersucht werden sollen. In der DE 103 04 530 A1 ist eine Anordnung beschrieben, bei der in einem aerodynamischen Profil zumindest stellenweise Piezoaktuatoren eingebracht sind, deren Längenänderung bei elektrischer Beaufschlagung im Wesentlichen in Richtung der Ebenen der Deckhäute des Profils erfolgt, wobei das Profil einen vorderen Profilbereich sowie einen in der Abströmung liegenden hinteren Profilbereich aufweist und durch eine druckseitige sowie eine saugseitige Deckhaut begrenzt ist, die in einer Profilhinterkante zusammenlaufen. Die verwendeten piezoelektrischen Aktuatoren enthalten neben Schaltungsanschlüssen Piezoelemente mit sogenanntem Longitudinaleffekt (d33-Effekt), bei welchem die Längenänderung des piezoelektrischen Werkstoffs in Richtung des elektrischen Felds erfolgt, und gestatten ein effektives Einleiten von Kräften in das aerodynamische Profil. Bei den in der DE 103 04 530 A1 verwendeten piezoelektrischen Aktuatoren, die den d33-Effekt ausnutzen, ist die Längenänderung des piezoelektrischen Werkstoffs in der Richtung des elektrischen Felds und größer als der Piezoeffekt (d31-Effekt), bei dem die Längenänderung senkrecht zum elektrischen Feld erfolgt.

Die in der DE 103 04 530 A1 verwendeten d33-Aktuatoren werden durch Schneiden eines stapelförmigen Piezoelements in Längsrichtung in flache Scheiben, die dann auf oder in eine gekrümmte Struktur, nämlich das aerodynamische Profil, eingebracht werden, erzeugt. Die Aktuatoren weisen eine geringe Dicke auf und sind im Wesentlichen plattenförmig oder flache Quader, so dass sie die aerodynamischen Verhältnisse nicht oder nur gering beeinflussen. Da jedoch der piezoelektrische Aktuator auf gekrümmte oder geformte Profile aufgebracht werden soll oder in diese eingebracht werden soll und keinen aerodynamischen Widerstand am aerodynamischen Profil erzeugen soll, müssen die in den Piezoaktuatoren enthaltenen Piezoelemente häufig gebogen oder gekrümmt werden, wobei sie beim Anpassen bzw. Aufbringen auf solche gekrümmten Strukturen leicht brechen, zumal die d33-Piezomaterialien an sich verhältnismäßig spröde sind. Zudem werden die Schichten des Piezoelements möglicherweise gegeneinander verschoben oder verformt, was wiederum die Genauigkeit und Funktionsfähigkeit des Piezomaterials beeinflussen kann.

Daher werden häufig gewöhnliche d31- Piezoelemente verwendet, bei welchen die Längenänderung senkrecht zum elektrischen Feld erfolgt und die daher dünner gestaltet werden können und verformungsnachgiebiger sind. Allerdings ist der Piezoeffekt bzw. die erzielbare aktive Verformung geringer, so dass die Leistung der d31- Piezoelemente oft nicht zufriedenstellend ist, um Bauteile gezielt zu beeinflussen.

Ein piezoelektrischer Aktuator ist auch aus der US 4,803,763 bekannt. Dieser piezoelektrische Aktuator beinhaltet einen Verbund aus vielen piezoelektrischen Platten mit dazwischen angeordneten Elektroden. Mehrere Reihen metallischer Stränge bzw. Vorsprünge sind an den Elektroden an der Außenseite des Verbunds angebracht und jede Reihe der metallischen Stränge ist mit den Elektroden elektrisch verbunden, so dass der Verbund parallel an elektrischen Strom angeschlossen wird, wenn jede Reihe an elektrischen Strom angeschlossen wird.

Weitere Aktuatoren sind aus US 6 404 107 B1, WO 96/31333 A1, EP 0 100 275 A1, WO 01/31715 A1, DE 197 32 571 A1 und DE 197 12 034 A1 bekannt.

Davon ausgehend ist es Aufgabe der Erfindung, ein Piezoelement und einen mit diesem Piezoelement gestalteten Aktuator zur Beeinflussung eines mechanischen Bauteils vorzusehen, welcher hohe Leistung aufweist und an die Form des Bauteils und/oder die Form der auftretenden und/oder aufzubringenden Belastung angepasst ist.

Diese Aufgabe wird mit einem piezoelektrischen Aktuator mit den Merkmalen des Anspruchs 1 gelöst. Bevorzugte Ausführungsformen sind in den abhängigen Ansprüchen angegeben.

Dadurch, dass eine Fläche des Stapelpiezoelements, die einer Fläche des Ausgangsstapelpiezoelements in Quaderform entspricht, welche senkrecht zu den Schichtebenen des Stapels bzw. parallel zur Stapelrichtung liegt, geformt ist, kann das Stapelpiezoelement eine dreidimensionale Formgebung aufweisen und beispielsweise an die Gestalt eines aerodynamischen Profils angepasst werden. Aufgrund der Tatsache, dass der Piezoeffekt senkrecht zu den Schichtebenen, d.h. in Stapelrichtung, auftritt, ist trotz der Formgebung die Leistung des Piezoelements nicht beeinflusst.

Unter geformter Fläche wird dabei verstanden, dass die Fläche anders als eine Ebene gestaltet ist, d.h. dass eine Seitenfläche des Quaders des Ausgangsstapels eines Stapelpiezoelements durch beispielsweise eine gekrümmte, gewellte oder anderweitig gestaltete Fläche ersetzt ist. In jedem Fall haben die das Stapelpiezoelement bildenden Schichten aus elektrisch leitfähigem Material nicht alle die gleiche Form. Formung einer Fläche bedeutet also mit anderen Worten, dass bei einer virtuellen Zerlegung des Stapelpiezoelements in die einzelnen leitfähigen Schichten die einzelnen Platten des Stacks verschiedene Plattenformen aufweisen. Für die Gestaltung der Flächen gibt es keine spezielle Beschränkung, sondern sie können vielmehr nach Bedarf an den entsprechenden Anwendungsfall des Piezoelements angepasst werden.

Als geformte Fläche wird somit jedes dreidimensional (3D) bearbeitetes Stapelelement verstanden, wobei tung die Bearbeitung in einer als dreidimensionale Bearbeitung eine Bearbeitung in mehreren Ebenen des Stapelpiezoelements bezeichnet wird, aus der ein nahezu beliebig konturiertes Stapelpiezoelement mit frei gestaltbaren Berg- und Talformen entsteht. Bei der dreidimensionalen Bearbeitung ist die Kontur des Piezoelements Funktion aller drei Raumrichtungen, während bei einer zweidimensionalen Bearbeitung die Kontur des Piezoelements in einer der drei Raumrichtungen nicht variiert.

Die Formung der geformten Fläche erfolgt nach dem Ausbilden des Piezoelements indem beispielsweise ein spanendes Formgebungsverfahren, insbesondere z.B. Sägen, Schleifen, Bohren, Drehen, Räumen, Läppen und Fräsen oder Kombinationen dieser Verfahren, angewendet wird.

Somit kann für einen d33-Piezoaktuator in gewöhnlicher Weise zunächst ein Piezoelement als Stapel oder Stack aufgebaut werden, d.h. in nicht formangepasster Form als Quader mit z.B. zwei näherungsweise quadratischen Seitenflächen, die gleichzeitig Schichtebenenflächen sind. Anschließend wird vor dem Anbringen an einem Bauteil bzw. der Verwendung als Aktuator zumindest eine Fläche des Stacks an die Form des Bauteils, die erwartete Belastung für das Piezoelement oder aber auch die durch das Piezoelement einzubringende Belastung oder Kombinationen dieser Anforderungen angepasst, indem zumindest eine Fläche des quaderförmigen Stacks, die parallel zur Stapelrichtung ist, z.B. mechanisch, spanend bearbeitet wird.

Bei aerodynamischen Anwendungen ist es beispielsweise bevorzugt, dass die formangepasste Fläche des piezoelektrischen Aktuators, nämlich die der Profilaußenseite eines aerodynamischen Profils zugewandte Fläche, gekrümmt ist, dass sie der Profilkontur entspricht. Damit kann die aerodynamische Form des Profils im Wesentlichen unbeeinflusst bleiben, trotz der Tatsache, dass eine Beeinflussung des aerodynamischen Bauteils mittels des Piezoelements möglich ist. In der Dickenrichtung kann das Piezoelement beispielsweise konstante Dicke aufweisen, was bedeutet, dass die der geformten Fläche gegenüberliegende Fläche ebenfalls in entsprechender Weise geformt ist, so dass das Piezoelement z.B. eine konkav gekrümmte und eine konvex gekrümmte Außenfläche besitzt. Alternativ kann das Piezoelement z.B. eine variable Dicke aufweisen, indem beispielsweise gar keine oder eine andere Formgebung an den anderen Flächen vorgenommen wird.

Durch Variation der Dicke kann das Piezoelement beispielsweise an Belastungen, die am Bauteil auftreten und in das Piezoelement eingeleitet werden, angepasst werden. Auch kann bei einem dreidimensionalen Profil durch eine variable Dicke des Piezoelements eine dreidimensionale Beeinflussung des Bauteils erzielt werden.

Bevorzugterweise ist das eingesetzte Piezoelement ein d33-Stapelpiezoelement, bei dem der Piezoeffekt in der Richtung senkrecht zu den Stapelschichten, d.h. in Stapelrichtung, auftritt. Aufgrund der Formgebung der Aktuatoren bzw. der Stapelpiezoelemente müssen die Aktuatoren beim Einbau nicht weiter gebogen oder verformt werden, so dass eine Gefahr des Bruchs beim Einbau, beispielsweise mittels Kleben, Klemmen oder Schrauben, aufgrund der Biegung sowie eine Verformung innerhalb der Schichten bzw. der Schichten zueinander vermieden wird. Damit bleibt die Leistung des Piezoaktuators erhalten und der Verschleiß der Piezoaktuatoren ist geringer.

Nachfolgend wird die Erfindung beispielhaft anhand der beigefügten Figuren beschrieben, in denen zeigt
- **Fig. 1a**: eine schematische Darstellung eines stapelförmigen piezoelektrischen Elements zur Erläuterung des d33-Effektes;
- **Fig. 1b**: eine schematische Darstellung eines stapelförmigen piezoelektrischen Elements zur Erläuterung des d31-Effektes;
- **Fig. 2a**: einen piezoelektrischen Aktuator, der nicht in der umfang der vorliegender Erfindung fällt, mit zwei dreidimensionalen Stapelpiezoelementen gemäß der Erfindung zur Biegung einer Platte;
- **Fig. 2b**: einen weiteren piezoelektrischen Aktuator zur Biegung einer Platte;
- **Fig. 3a**: einen piezoelektrischen Aktuator gemäß der Erfindung zur Biegung einer Schale;
- **Fig. 3b**: einen alternativen piezoelektrischen Aktuator gemäß der Erfindung zur Biegung einer Schale;
- **Fig. 4a**: einen piezoelektrischen Aktuator zum Beeinflussen eines aerodynamischen Profils durch Biegung, Beulen oder Wölbung;
- **Fig. 4b**: einen alternativen piezoelektrischen Aktuator zur Beeinflussen eines Profils durch Biegung, Beulen oder Wölbung;
- **Fig. 5**: einen piezoelektrischen Aktuator gemäß der Erfindung zum Beeinflussen eines Bauteils durch Torsion und Beulung;
- **Fig. 6**: eine perspektivische Ansicht der Anordnung von piezoelektrischen Aktuatoren gemäß der Erfindung an einem aerodynamischen Profil ist;
- **Fig. 7a**: ein variabel konturiertes dreidimensionales Stapelpiezoelement gemäß der Erfindung; und
- **Fig. 7b**: ein segmentiertes dreidimensionales Stapelpiezoelement gemäß der Erfindung.

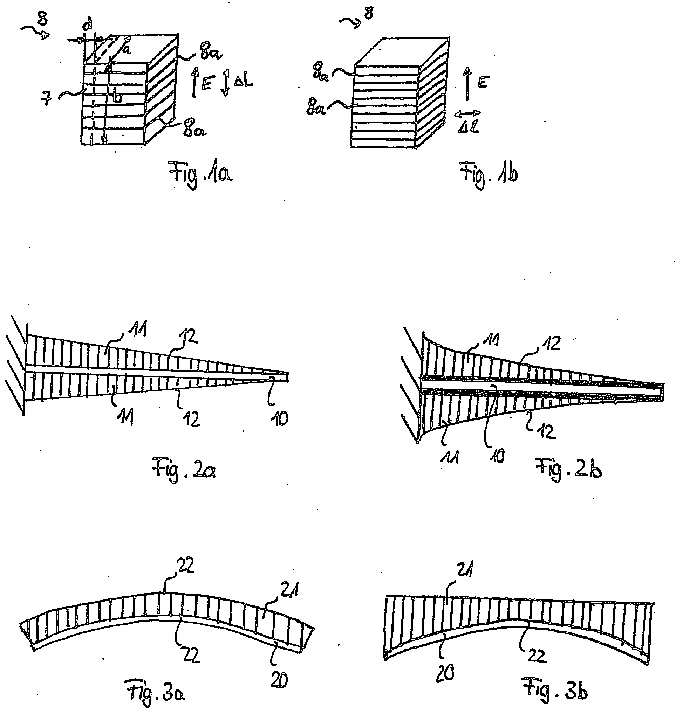

Fig. 1a und 1b zeigen in schematischer Darstellung ein stapelförmiges piezoelektrisches Element 8, das auch als "Piezostack" bezeichnet wird. Das Piezoelement besteht jeweils aus alternierend angeordneten Schichten aus elektrisch leitfähigem und piezoelektrischem Material. Die Schichten sind bei den Stacks in Fig. 1a und 1b jeweils quaderförmig und besitzen in der Richtung senkrecht zur Stapelrichtung die gleiche Querschnittsform. Die Schichten aus elektrisch leitfähigem Material stellen Elektroden 8a dar. Bei dem Piezoelement gemäß Fig. 1a liegt das elektrische Feld E in Stapel- bzw. Längsrichtung des piezoelektrischen Elements 8 an. Das elektrische Feld E wird über die Elektroden 8a bereitgestellt. Aufgrund des elektrischen Felds E dehnt sich der piezoelektrische Werkstoff in Richtung des elektrischen Felds E aus. Diese Längenänderung ist in Fig. 1a mit ΔL bezeichnet. Die Abmessungen eines Stapels betragen typischerweise als Seitenlänge a der Flächen der Stapelelemente senkrecht zur Stapelrichtung etwa 5-60 mm, ebenso wie die Höhe b in Stapelrichtung.

Bei dem in Fig. 1a gezeigten Piezoelement 8, das ein sogenanntes d33-Piezoelement ist, ist die Längenänderung ΔL bei Anlegen eines elektrischen Felds größer als die Längenänderung ΔL bei einem Piezoelement mit d31-Effekt (siehe Fig. 1 b), bei dem die Längenänderung ΔL quer zum elektrischen Feld E erfolgt.

Gemäß der DE 103 04 530 A1 ist es bekannt, Schichten mit Schichtdicke d aus den Stacks gemäß Fig. 1a zu schneiden und auf beispielsweise aerodynamische Profile aufzubringen.

Ausgehend von einem d33-Piezostak gemäß Fig. 1a wird zur Ausführung der Erfindung zumindest eine Seitenfläche von zumindest einem Teil der den Stapel bildenden Schichten, d.h. der plattenförmigen Elemente, die senkrecht zu den Schichtebenen des Stapels ist, mechanisch durch beispielsweise spanende Formgebung bearbeitet. In Betracht kommen Formgebungsverfahren, wie Sägen, Schleifen, Bohren, Drehen, Räumen, Läppen und/oder Fräsen. Daraus resultiert ein geformtes Piezoelement, bei dem wenigstens eine Seitenfläche beispielsweise gekrümmt oder zwar eben aber unter einem Winkel zur Stapelrichtung ist, so dass sie nicht mehr parallel zur Stapelrichtung ist, und das gesamte Piezoelement nicht mehr quaderförmig ist. Dies bedeutet, dass die einzelnen Schichtebenen nicht mehr gleiche Querschnittsform in der Richtung senkrecht zur Stapelrichtung aufweisen.

Ein derartiges Stapelpiezoelement, für das vorzugsweise ein Stapelpiezoelement mit d33-Effekt verwendet wird, kann als piezoelektrischer Aktuator verwendet werden, indem zugehörige elektrische Anschlüsse in bekannter Weise ergänzt werden. Anwendungen dafür sind in Fig. 2a bis 7b gezeigt.

In Fig. 2a ist dargestellt, wie zwei jeweils prismaförmige Piezoelemente, d.h. mit dreiecksförmigem Querschnitt bzw. mit variierender Dicke, in der Ansicht gemäß Fig. 2a, auf die Ober- und Unterseite einer biegsamen Trägerplatte 10 aufgebracht sind. Jeweils ein Piezoelement 11 ist auf der Oberseite und ein Piezoelement 11 auf der Unterseite der Trägerplatte 10 angebracht. Dabei sind in der in Fig. 2a dargestellten Ausführungsform die Piezoelemente 11 spiegelsymmetrisch zueinander. Die Aktuierung ist derart, dass die Piezoelemente entgegengesetzt angetrieben werden, was bedeutet, dass sich ein Piezoaktuator 11 ausdehnt, während sich der andere gleichzeitig zusammenzieht. Dadurch kann in die Platte 10 eine Biegung eingeleitet werden und beispielsweise das den, indem zugehörige elektrische Anschlüsse in bekannter Weise ergänzt werden. Anwendungen dafür sind in Fig. 2a bis 7b gezeigt.

In Fig. 2a ist dargestellt, wie zwei jeweils prismaförmige Piezoelemente, d.h. mit dreiecksförmigem Querschnitt bzw. mit variierender Dicke, in der Ansicht gemäß Fig. 2a, auf die Ober- und Unterseite einer biegsamen Trägerplatte 10 aufgebracht sind. Jeweils ein Piezoelement 11 ist auf der Oberseite und ein Piezoelement 11 auf der Unterseite der Trägerplatte 10 angebracht. Dabei sind in der in Fig. 2a dargestellten Ausführungsform die Piezoelemente 11 spiegelsymmetrisch zueinander. Die Aktuierung ist derart, dass die Piezoelemente entgegengesetzt angetrieben werden, was bedeutet, dass sich ein Piezoaktuator 11 ausdehnt, während sich der andere gleichzeitig zusammenzieht. Dadurch kann in die Platte 10 eine Biegung eingeleitet werden und beispielsweise das Biegeverhalten der Platte untersucht oder gesteuert werden. Alternativ können die Piezoelemente auch verwendet werden, um Belastungen an der Platte zu erfassen, indem der Stromfluss, der durch die in den Piezoelementen bewirkte Längenänderung erzeugt wird, gemessen wird.

Bei der in Fig. 2a dargestellten Ausführungsform, die nicht in der umfang der vorliegender Erfindung fällt sind die Formen der Piezoelemente 11 an die in die Trägerplatte 10, die beispielsweise aus Verbundmaterial gefertigt ist, einzubringende Belastung angepasst. Die Piezoelemente 11 sind mit der Trägerplatte 10 z.B. durch Kleben verbunden. Alternativ ist es auch möglich, die Piezoelemente 11 direkt miteinander zu verbinden, um ein verformbares Bauteil zu erhalten.

Bei der in Fig. 2b dargestellten Ausführungsform ist die Gestalt der Piezoelemente 11, die ebenfalls eine Biegeplatte 10 zur Biegung bringen sollen, der einzubringenden Belastung noch besser angepasst, indem im Querschnitt der Piezoelemente die Momentenlinie am Biegebalken 10 nachgezeichnet wird. Durch die Formgebung der Piezoelemente 11 mit zumindest einer gekrümmten Fläche ist es somit möglich, die Form der Piezoelemente 11 an die in das zu beeinflussende Bauteil, hier die Biegeplatte 10, einzubringenden Lasten anzupassen.

Die geformte Fläche 12 des Stapels 8 ist die in den Querschnittsansichten gemäß Fig. 2a und 2b obere bzw. untere Fläche des Piezoelements 11.

Fig. 3a und 3b zeigen die Anwendung von gemäß der Erfindung geformten Piezoelementen 21 für schalenartige Bauteile 20, beispielsweise Hohlspiegel für Teleskope. Dabei zeigt Fig. 3a eine Anordnung, bei der wenigstens zwei Flächen 22 eines Piezostacks 8 gemäß Fig. 1a bearbeitet sind, dass jeweils gekrümmte Flächen daraus resultieren, nämlich einerseits die am Schalenbauteil 20 angebrachte Fläche 22 und die dieser gegenüberliegende Fläche 22. In Fig. 3b ist im Gegensatz dazu nur eine der Flächen 22 der Stacks 8 derart bearbeitet, dass ihre Kontur derjenigen des Schalenbauteils 20 angepasst ist. In beiden Fällen ist es möglich, ohne mechanische Beanspruchung des Piezoelements beim Aufbringen auf ein gekrümmtes Bauteil ein Piezoelement mit d33-Effekt mit einem gekrümmten Bauteil 20 zu verbinden. Bei der Herstellung des mit zwei gewölbten Flächen 22 gebildeten Piezoaktuators gemäß Fig. 3a wird zunächst die dem Bauteil 20 zugewandte konkave Form geformt, und anschließend die gegenüberliegende Seite derart abgetragen, dass die konvexe Wölbung erhalten wird.

Die geformten Flächen gemäß Fig. 3a sind die konkav und konvex gewölbten Flächen 22, die an dem schalenförmigen Bauteil anliegen bzw. diesem abgewandt sind, bei der Ausführungsform in Fig. 3b nur die dem schalenförmigen Bauteil zugewandte Fläche.

Mit den Piezoaktuatoren gemäß Fig. 3a und 3b kann somit auf gekrümmte Flächen ein Piezoaktuator aufgebracht werden, ohne dass beim Aufbringen der Piezoaktuator gebogen werden muss und somit das Piezoelement möglicherweise beschädigt wird. Die Verwendung von Piezoaktuatoren für schalenartige Bauteile, beispielsweise Spiegel, bietet die Möglichkeit, dass beispielsweise für Teleskopspiegel die Kontur der Wölbung mit durch andere Mittel unerreichbarer Präzision eingestellt werden kann, was die Funktion des Teleskopspiegels deutlich verbessert. Die Piezoaktuatoren können der Kontur, insbesondere der Krümmung, des Schalenelements 20 vollständig angepasst werden.

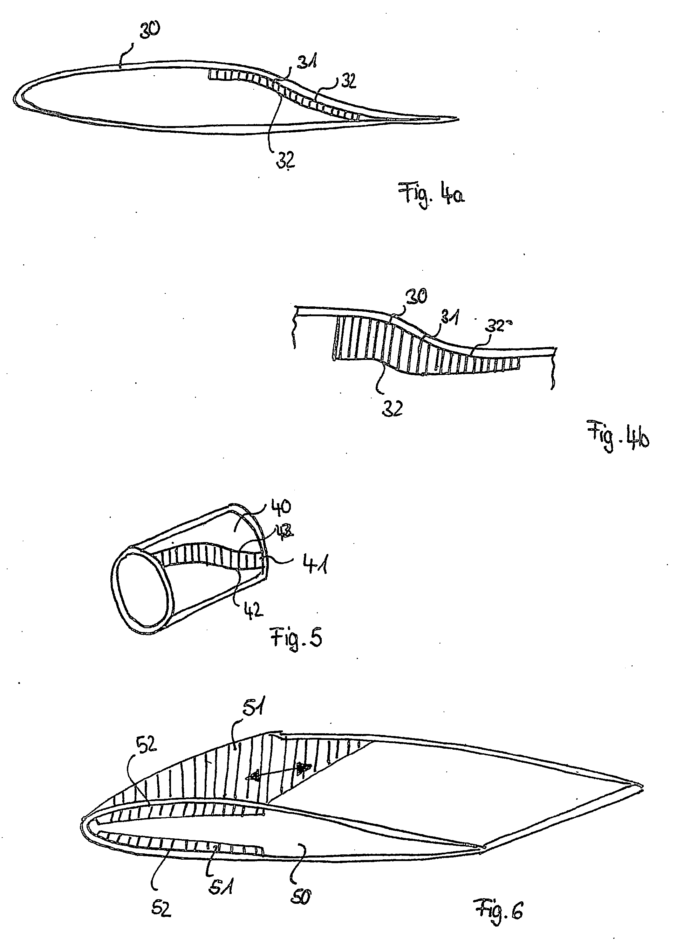

Dies ist beispielsweise auch vorteilhaft, wenn, wie in Fig. 4a und 4b gezeigt, die Piezoaktuatoren 31 für die Beeinflussung von aerodynamischen Profilen 30 verwendet werden. In Fig. 4a ist ein Piezoaktuator 31 mit gleichmäßiger Dicke gezeigt, während der Piezoaktuator 31 aus Fig. 4b eine der einzubringenden Last bzw. Verformung oder Beeinflussung des Bauteils angepasste Dicke aufweist. Durch einen derartigen Piezoaktuator 31 kann beispielsweise das aerodynamische Profil 30 gebogen, gebeult oder gewölbt werden, ohne dass die Oberfläche des aerodynamischen Profils merklich beeinflusst wird. Somit können die Strömungseigenschaften um das aerodynamische Profil 30 untersucht bzw. variiert werden. Dadurch dass die Kontur der Piezoaktuatoren 31 vollständig der Außenfläche des aerodynamischen Profils angepasst ist, ohne dass das Piezoelement 31 durch Biegen von ihm selbst der Form angepasst werden muss, können nahezu beliebig geformte Bauteile mit derartigen Piezoaktuatoren mit hoher Wirksamkeit beeinflusst oder verformt werden und, wenn die Dicke des Piezoaktuators 31 auf die Belastungsart angepasst ist, ohne Verformung der Außenkontur.

Die geformten Flächen entsprechen den Flächen 32, welche die Kontur des aerodynamischen Profils nachzeichnen. In Fig. 4b ist die untere konturierte Fläche in Abhängigkeit von den einzubringenden Belastungen in das aerodynamische Profil 30 gewählt, so dass eine dreidimensionale Beeinflussung des Profils 30 möglich ist.

In Fig. 5 ist eine Anordnung gezeigt, bei der ein schalen- oder zylinderförmiges Bauteil 40 mittels eines Piezoaktuators 41, der konstante Dicke in der dargestellten Ausführungsform aufweist, auf Torsion und Beulung beansprucht werden kann.

Die Formgebung des Piezoaktuators 41 erfolgt vorzugsweise dreidimensional, d.h. dass aus dem ursprünglichen Piezostack 8, der in Fig. 1a dargestellt ist, durch spanförmige Abtragung dreidimensionale Körper geformt werden, ohne dass die Schichtungsflächen zueinander verschoben oder gedehnt bzw. auf Zug oder Spannung beansprucht werden.

In Fig. 6 ist ein aerodynamisches Profil 50 gezeigt, bei dem mehrere d33-Piezoaktuatoren 51 mit jeweils angepasster Oberflächenform segmentförmig angeordnet sind. Die Außenkontur des aerodynamischen Profil 50 wird durch die Piezoaktuatoren 51 nicht gestört, da die späteren Außenflächen 52 der Piezoaktuatoren durch mechanische Bearbeitung eines Stacks entsprechend formangepasst sind. Die Anordnung der Piezoaktuatoren am aerodynamischen Profil 50 ist dabei derart, dass die Richtung des d33-Effekts von Segment zu Segment unterschiedlich sein kann und somit eine gezielte dreidimensionale Beeinflussung des Bauteils 50 möglich ist. Die Beeinflussungsrichtung des in Fig. 6 oberen Piezoaktuators 51 ist mit einem Pfeil angegeben (entspricht Richtung der Längenänderung). Die Piezoaktuatoren 51 sind somit derart in die Struktur integriert, dass sie vollständig der Kontur angepasst sind, indem geeignete Geometrien aus dem Stack 8 geschnitten werden, und auch ihre Elongationsrichtung an die aufzubringende Beeinflussung angepasst ist. Nach Bedarf kann die Beeinflussungsrichtung auch mit anisotropen Eigenschaften der Basisstruktur, z.B. des dafür verwendeten Werkstoffs, kombiniert werden, so dass die Elongationsrichtung gezielt genutzt wird, um bestimmte Beeinflussungen durch den Piezoaktuator 51 in das aerodynamische Profil 50 einzubringen.

Schließlich ist es auch möglich, durch geeignete Wahl der Geometrie des Piezoaktuators diesen im Hinblick auf in das Grundbauteil eingeleitete Lasten möglichst unempfindlich zu machen, indem der Piezoaktuator selbst durch Wahl einer dreidimensionalen Form bezüglich seiner Steifigkeit und Belastungsaufnahmefähigkeit an die erwarteten Kräfte bzw. Momente angepasst ist.

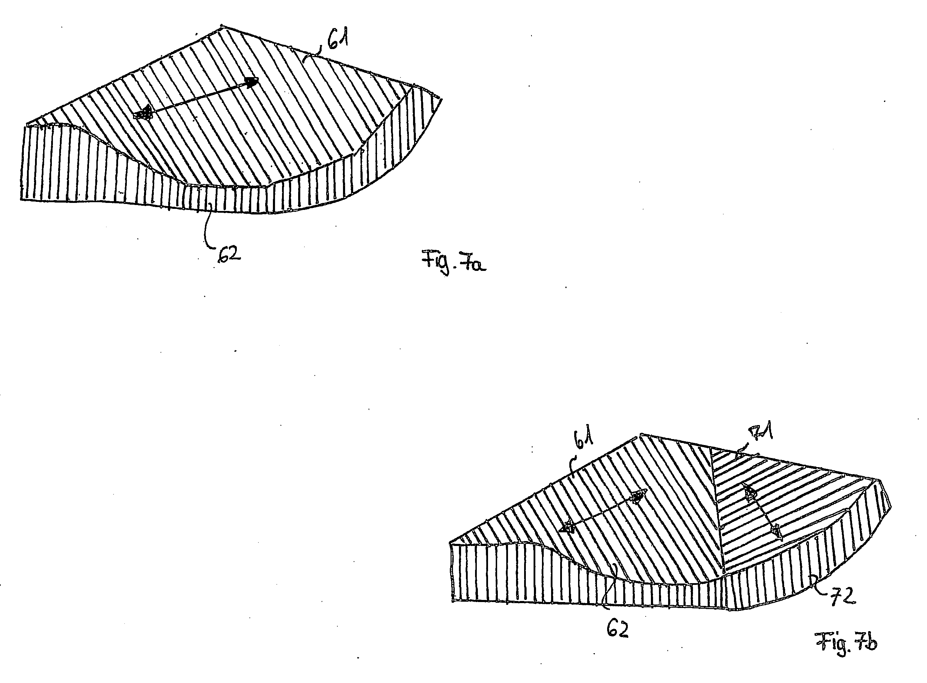

Fig. 7a und 7b zeigen schließlich einen dreidimensional formangepassten Piezoaktuator, wobei in Fig. 7b ein segmentförmiger Piezoaktuator mit unterschiedlicher Richtung des d33-Effekts vorgesehen ist, da der Piezoaktuator aus mehreren geformten Stacks gebildet und an sich segmentiert ist. Die Richtung des d33-Effekts (Längenausdehnungsrichtung) ist mit einem Pfeil bezeichnet. Es ist zu erkennen, dass der Piezoaktuator 61 bzw. 71 sowohl konturiert ist als auch variable Dicke aufweist. Durch die Orientierung der aktiven Richtung des d33-Effekts entsprechend der Zielsetzung, insbesondere bei zusätzlicher Segmentierung, können nahezu beliebige Beeinflussungen in das Bauteil eingebracht werden.

Der wesentliche Aspekt der Erfindung liegt darin, statt eines herkömmlichen quaderförmigen Stacks aus piezoelektrischen Materialien und Elektroden einen solchen Stack nach dem Stapeln zumindest an einer Oberfläche des Stapels, die senkrecht zu dem Stapelebenen ist, so zu formen, dass der Piezoaktuator an die Form eines Bauteils, an die von ihm zu erzeugenden Belastungen und/oder die für den Piezoaktuator entsprechend erwarteten Belastungen angepasst ist.

## Patentansprüche

1. Piezoelektrischer Aktuator mit einem dreidimensionalen Stapelpiezoelement (11, 21, 31, 41, 51, 61) mit mehreren Piezoschichten zur Anbringung an einer Basisstruktur, **dadurch gekennzeichnet, dass** zumindest eine Seitenfläche (12,22,32,42,52,62) eines Quaders eines Ausgangsstapels des Stapelpiezoelements senkrecht zu Schichtebenen (8a) des Stapels dreidimensional geformt und anders als eine Ebene gestattet ist.

2. Piezoelektrischer Aktuator nach Anspruch 1, **dadurch gekennzeichnet, dass** die zumindest eine Fläche (12, 22, 32. 42, 52, 62) des Stapelpiezoelements zumindest abschnittsweise nicht parallel zu einer Stapelrichtung des Piezoelements ist.

3. Piezoelektrischer Aktuator nach Anspruch 1 oder 2, **dadurch gekennzeichnet, dass** die zumindest eine geformte Fläche (12, 22, 32, 42, 52, 62) des Stapelpiezaelements gekrümmt ist.

4. Piezoelektrischer Aktuator nach einem der vorhergehenden Ansprüche, **dadurch gekennzeichnet, dass** das Stapelpiezoelement ein d33 Piezoelement ist.

5. Piezoelektrischer Aktuator nach einem der vorhergehenden Ansprüche, **dadurch gekennzeichnet, dass** die zumindest eine geformte Fläche (12, 22, 32, 42, 52, 62) durch spanende Bearbeitung, insbesondere Sägen, Schleimen, Bohren, Drehen, Räumen, Läppen und/oder Fräsen gebildet ist.

6. Piezoelektrischer Aktuator nach einem der vorhergehenden Ansprüche, **dadurch gekennzeichnet, dass** die geformte Fläche durch zweidimensionale oder dreidimensionale Bearbeitung in mindestens einer Ebene geformt wird.

7. Piezoelektrischer Aktuator nach einem der vorhergehenden Ansprüche, **dadurch gekennzeichnet, dass** die Gestalt der zumindest einen geformten Fläche (12, 22, 32, 42, 52, 62) des Piezoelements an die durch das Piezoelement aufzubringende Beeinflussung einer Basisstruktur angepasst ist.

8. Piezoelektrischer Aktuator nach einem der vorhergehenden Ansprüche, **dadurch gekennzeichnet, dass** die Gestalt der zumindest einen geformten Fläche (12, 22, 32, 42, 52, 62) des dreidimensionalen Piezoelements an die für das Piezoelement erwartete mechanische Belastung angepasst ist.

9. Piezoelektrischer Aktuator nach einem der vorhergehenden Ansprüche, **dadurch gekennzeichnet, dass** der Aktuator mindestens zwei Segmente aus dreidimensionalen Stapelpiezoelementen enthält.

10. Piezoelektrischer Aktuator nach Anspruch 9, **dadurch gekennzeichnet, dass** die Orientierung der Stapelrichtungen der Segmente unterschiedlich ist.

11. Piezoelektrischer Aktuator nach Anspruch 9 oder 10, **dadurch gekennzeichnet, dass** die Segmente unabhängig voneinander betreibbar sind.

12. Aerodynamisches Profil mit einem piezoelektrischen Aktuator nach einem der vorhergehenden Ansprüche.

13. Aerodynamisches Profil nach Anspruch 12, **dadurch gekennzeichnet, dass** der Aktuator derart in das Profil integriert ist, dass das Profil eine im Wesentlichen glatte Oberfläche aufweist.

14. Aerodynamisches Profil nach Anspruch 12 oder 13, **dadurch gekennzeichnet, dass** mehrere piezoelektrische Aktuatoren vorgesehen sind, die voneinander unabhängig betreibbar an verschiedenen Positionen am oder im Profil vorgesehen sind.

## Claims

1. Piezoelectric actuator having a three-dimensional stacked piezo element (11, 21, 31, 41, 51, 61) comprising a number of piezo layers for attachment to a base structure, **characterized in that** at least one side face (12, 22, 32, 42, 52, 62) of a cuboid of an initial stack of the stacked piezo element is three-dimensionally shaped perpendicularly to layer planes (8a) of the stack and configured unlike a plane.

2. Piezoelectric actuator according to Claim 1, **characterized in that** at least certain portions of the at least one face (12, 22, 32, 42, 52, 62) of the stacked piezo element are not parallel to a stacking direction of the piezo element.

3. Piezoelectric actuator according to Claim 1 or 2, **characterized in that** the at least one shaped face (12, 22, 32, 42, 52, 62) of the stacked piezo element is curved.

4. Piezoelectric actuator according to one of the preceding claims, **characterized in that** the stacked piezo element is a d33 piezo element.

5. Piezoelectric actuator according to one of the preceding claims, **characterized in that** the at least one shaped face (12, 22, 32, 42, 32, 62) is formed by machining, in particular sawing, grinding, drilling, turning, broaching, lapping and/or milling.

6. Piezoelectric actuator according to one of the preceding claims, **characterized in that** the shaped face is shaped by two-dimensional or three-dimensional machining in at least one plane.

7. Piezoelectric actuator according to one of the preceding claims, **characterized in that** the configuration of the at least one shaped face (12, 22, 32, 42, 52, 62) of the piezo element is adapted to the way in which a basic structure should be influenced by the piezo element.

8. Piezoelectric actuator according to one of the preceding claims, **characterized in that** the configuration of the at least one shaped face (12, 22, 32, 42, 52, 62) of the three-dimensional piezo element is adapted to the mechanical loading expected for the piezo element.

9. Piezoelectric actuator according to one of the preceding claims, **characterized in that** the actuator includes at least two segments of three-dimensional stacked piezo elements.

10. Piezoelectric actuator according to Claim 9, **characterized in that** the orientation of the stacking directions of the segments varies.

11. Piezoelectric actuator according to Claim 9 or 10, **characterized in that** the segments can be operated independently of one another.

12. Aerodynamic profile with a piezoelectric actuator according to one of the preceding claims.

13. Aerodynamic profile according to Claim 12, **characterized in that** the actuator is integrated in the profile in such a way that the profile has a substantially smooth surface.

14. Aerodynamic profile according to Claim 12 or 13, **characterized in that** a number of piezoelectric actuators are provided, and are provided such that they can be operated independently of one another at different positions on or in the profile.

## Revendications

1. Actionneur piézoélectrique comprenant un élément piézoélectrique en pile (11, 21, 31, 41, 51, 61) tridimensionnel avec plusieurs couches piézoélectriques destiné à être monté sur une structure de base, **caractérisé en ce qu'**au moins une surface latérale (12, 22, 32, 42, 52, 62) d'un parallélépipède d'une pile d'origine de l'élément piézoélectrique en pile est façonnée en trois dimensions perpendiculairement aux plans des couches (8a) de la pile et configurée différemment d'un plan.

2. Actionneur piézoélectrique selon la revendication 1, **caractérisé en ce que** l'au moins une surface (12, 22, 32, 42, 52, 62) de l'élément piézoélectrique en pile n'est pas, au moins dans certaines sections, parallèle à un sens d'empilement de l'élément piézoélectrique.

3. Actionneur piézoélectrique selon la revendication 1 ou 2, **caractérisé en ce que** l'au moins une surface (12, 22, 32, 42, 52, 62) façonnée de l'élément piézoélectrique en pile est curviligne.

4. Actionneur piézoélectrique selon l'une des revendications précédentes, **caractérisé en ce que** l'élément piézoélectrique en pile est un élément piézoélectrique d33.

5. Actionneur piézoélectrique selon l'une des revendications précédentes, **caractérisé en ce que** l'au moins une surface (12, 22, 32, 42, 52, 62) façonnée est formée par usinage à enlèvement de copeaux, notamment sciage, rectification, perçage, tournage, brochage, rodage et/ou fraisage.

6. Actionneur piézoélectrique selon l'une des revendications précédentes, **caractérisé en ce que** la surface façonnée est formée par usinage bidimensionnel ou tridimensionnel dans au moins un plan.

7. Actionneur piézoélectrique selon l'une des revendications précédentes, **caractérisé en ce que** la configuration de l'au moins une surface (12, 22, 32, 42, 52, 62) façonnée de l'élément piézoélectrique est adaptée à l'influence d'une structure de base à exercer par l'élément piézoélectrique.

8. Actionneur piézoélectrique selon l'une des revendications précédentes, **caractérisé en ce que** la configuration de l'au moins une surface (12, 22, 32, 42, 52, 62) façonnée de l'élément piézoélectrique tridimensionnel est adaptée à la charge mécanique attendue pour l'élément piézoélectrique.

9. Actionneur piézoélectrique selon l'une des revendications précédentes, **caractérisé en ce que** l'actionneur contient au moins deux segments composés d'éléments piézoélectriques en pile tridimensionnels.

10. Actionneur piézoélectrique selon la revendication 9, **caractérisé en ce que** l'orientation du sens d'empilement des segments est différente.

11. Actionneur piézoélectrique selon la revendication 9 ou 10, **caractérisé en ce que** les segments peuvent être utilisés indépendamment l'un de l'autre.

12. Profil aérodynamique comprenant un actionneur piézoélectrique selon l'une des revendications précédentes.

13. Profil aérodynamique selon la revendication 12, **caractérisé en ce que** l'actionneur est intégré dans le profil de telle sorte que le profil présente une surface essentiellement lisse.

14. Profil aérodynamique selon la revendication 12 ou 13, **caractérisé en ce que** plusieurs actionneurs piézoélectriques sont prévus, lesquels peuvent être utilisés indépendamment les uns des autres et sont prévus à des positions différentes sur ou dans le profil.
